# EUROPEAN PATENT APPLICATION

(11) **EP 0 891 127 A2**
(43) Date of publication of application: **13.01.1999**
(21) Application number: 98112683.2
(22) Date of filing: 09.07.1998
(51) Int. Cl.: H05K 3/28, B41J 2/345, H01L 23/29, H01L 23/495

(54) **TAB circuit protective coating**

(30) Priority: 11.07.1997 US 891591
(71) Applicant: Lexmark International, Inc., Lexington, Kentucky 40550 (US)
(72) Inventor: Decoste, Jr. Charles Leonard,, Richmond, Kentucky 40475 (US); Vogel, Thomas Richard, Lexington, Kentucky 40503 (US)
(74) Representative: Dr. Weitzel & Partner

(57) **Abstract**

A TAB circuit is provided having a single layer protective coating on its under surface. Also provided is a process for forming such a TAB circuit. The TAB circuit comprises a circuit substrate having first and second surfaces, conductive traces formed on the first surface, and a single layer protective coating covering portions of the traces and first surface portions of the substrate. The coating comprises a resin, such as an epoxy. Polyurethanes, acrylates and like materials may also be used. The coating is applied via a conventional screen-printing process or a spray-coating process.

## Description

### FIELD OF THE INVENTION

This invention relates to a TAB circuit having a single layer protective coating on its under surface and to a process for forming such a TAB circuit.

### BACKGROUND OF THE INVENTION

Drop-on-demand ink jet printers use thermal energy to produce a vapor bubble in an ink-filled chamber to expel a droplet. A thermal energy generator or heating element, usually a resistor, is located in the chamber on a heater chip near a discharge orifice. A plurality of chambers, each provided with a single heating element, are provided in the printers printhead. The printhead typically comprises the heater chip and an orifice plate having a plurality of the discharge orifices formed therein. The printhead forms part of an ink jet print cartridge which also comprises an ink-filled container.

The resistors are individually addressed by energy pulses provided by a printer energy supply circuit. Each energy pulse is applied to one of the resistors to momentarily vaporize the ink in contact with that resistor to form a bubble which expels an ink droplet. A flexible circuit is used to provide a path for the energy pulses to travel from the printer energy supply circuit to the printhead. The flexible circuit includes a flexible substrate and a plurality of traces located on the substrate. The traces have end sections which extend out from the flexible substrate. The extending sections are coupled to bond pads on the printhead. Typically, there is a first row of coupled bond pads and trace sections and an opposing, second row of coupled bond pads and trace sections.

U.S. Patent No. 5,442,386 to Childers et al. teaches attaching a three-layer protective structure to the back side of a flexible circuit so as to encapsulate and insulate the traces on the circuit to protect the encapsulated portions of the traces from ink shorting. The protective structure comprises outer adhesive layers and an intermediate polyethylene terephthalate (PET) layer. It is believed that ink may reach the traces by wicking through the adhesive layer positioned between the PET layer and the flexible substrate. The ink would enter through outer edge portions of the adhesive layer.

It is desired to improve the reliability and reduce the cost of manufacturing TAB circuits.

### SUMMARY OF THE INVENTION

The instant invention is directed to a TAB circuit having a single layer protective coating on its under surface and to a process for forming such a TAB circuit. The TAB circuit comprises a circuit substrate having first and second surfaces, conductive traces formed on the first surface, and a single layer protective coating covering portions of the traces and first surface portions of the substrate. Preferably, the coating comprises a thermosetting resin, such as an epoxy. Polyurethanes, acrylates and like materials may also be used. The coating may be applied by a conventional screen-printing process or a spray-coating process.

### BRIEF DESCRIPTION OF THE DRAWINGS

Fig. 1 is a perspective view of a portion of an ink jet print cartridge having a flexible circuit formed in accordance with the present invention;
Fig. 2 is a view of a portion of a heater chip coupled to an orifice plate with sections of the orifice plate removed at two different levels;
Fig. 3 is an enlarged view of the printhead, a portion of the flexible circuit, and a portion of the ink-filled container shown in Fig. 1;
Fig. 4 is a top view of a portion of a TAB circuit constructed in accordance with the present invention; and
Fig. 5 is a view taken along view line 5-5 in Fig. 4.

### DETAILED DESCRIPTION OF THE PREFERRED EMBODIMENT

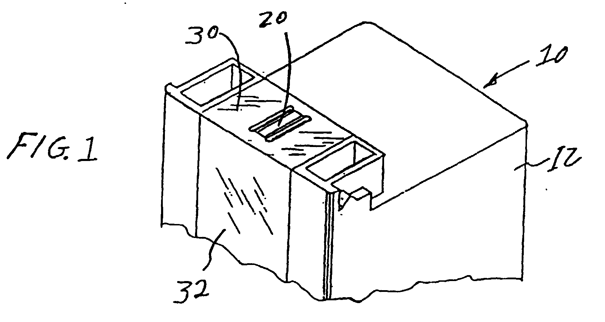

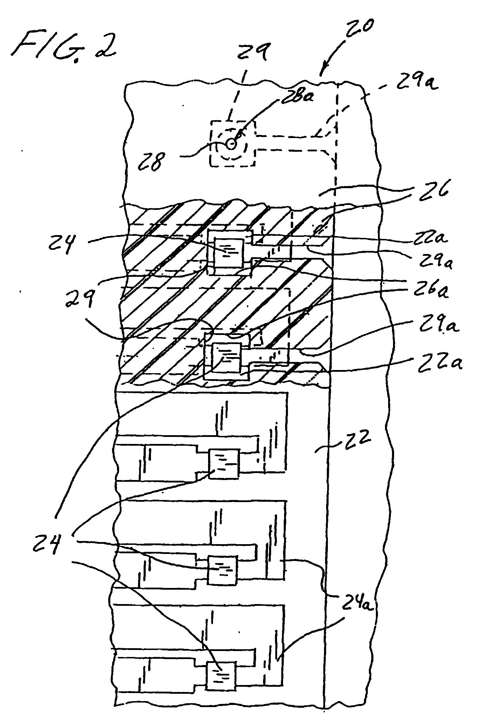

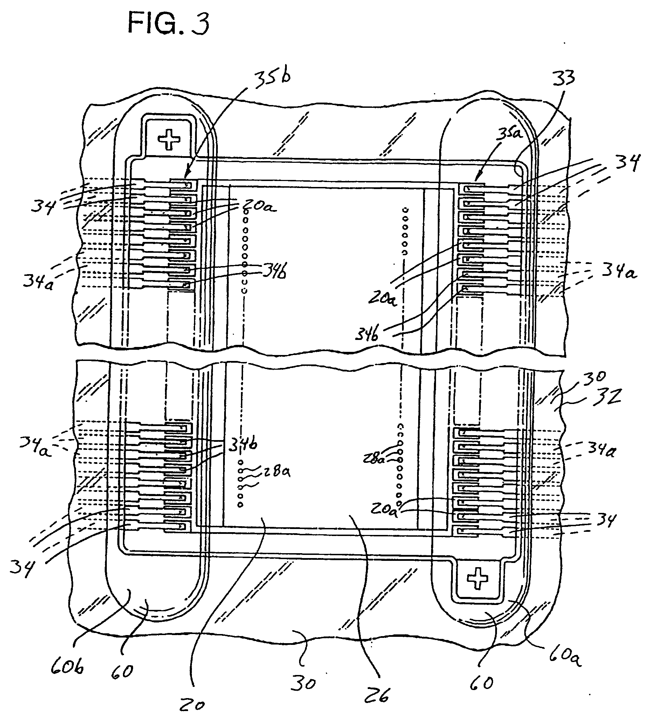

Referring now to Fig. 1, there is shown an ink jet print cartridge 10 having a flexible circuit 30 formed in accordance with the present invention. The print cartridge 10 is adapted to be used in an ink jet printer (not shown). The print cartridge 10 comprises an ink-filled container 12, a printhead 20 which is adhesively secured to the container 12, and the flexible circuit 30.

The printhead 20 comprises a heater chip 22 provided with a plurality of resistive heating elements 24, see Fig. 2. The printhead 20 further includes an orifice plate 26 having a plurality of openings 28 extending through it which define a plurality of orifices 28a through which ink droplets are ejected, see also Fig. 3. Sections 26a of the plate 26 and portions 22a of the heater chip 22 define a plurality of bubble chambers 29. Ink supplied by the container 12 flows into the bubble chambers 29 through ink supply channels 29a.

The resistive heating elements 24 are individually addressed by voltage pulses. Each voltage pulse is applied to a heating element 24 to momentarily vaporize the ink in contact with the heating element 24 to form a bubble within the chamber 29 in which the heating element 24 is located The function of the bubble is to displace ink within the chamber 29 such that a droplet of ink is expelled through the bubble chamber orifice 28a associated with that chamber 29.

The flexible circuit 30 provides a path for voltage pulses to travel from a printer energy supply circuit (not shown) to bond pads 20a, see Fig. 3, provided on the printhead 20. Conductors 24a extend from the bond pads 20a to the heating elements 24, see Fig. 2.

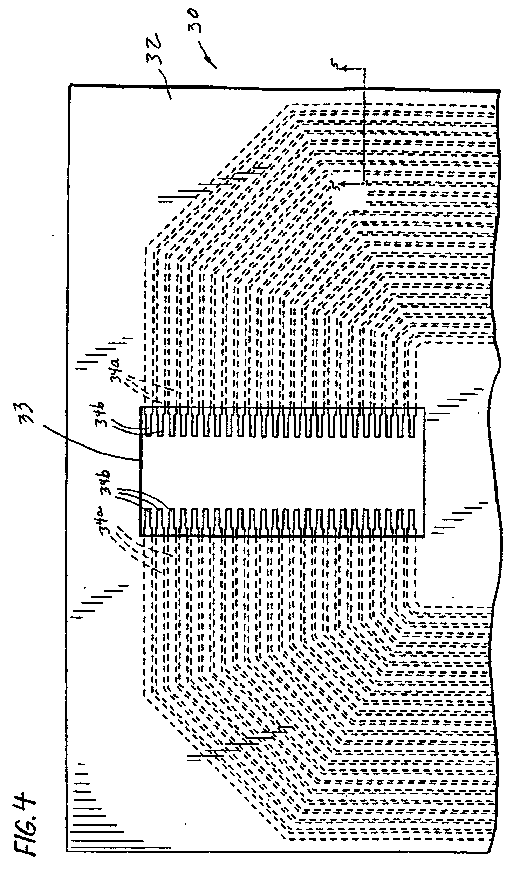

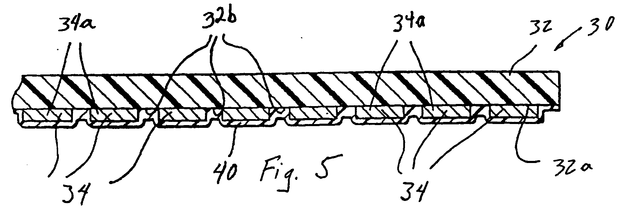

The flexible circuit 30 comprises a flexible substrate 32 having a plurality of conductive traces 34 formed on a first surface 32a thereof, see Fig. 5. The traces 34 comprise first portions 34a and second portions 34b, see Fig. 3. The first portions 34a are formed on the substrate first surface 32a. The second portions 34b extend out beyond an edge of a printhead-receiving opening 33 punched or otherwise formed in the substrate 32, see Fig. 4. The second portions 34b define beam leads.

In accordance with the present invention, a single layer coating 40 is formed over the first trace portions 34a and over exposed portions 32b of the substrate first surface 32a so as to encapsulate the first trace portions 34a between the substrate 32 and the coating 40 to prevent ink from reaching the first trace portions 34a. Ink can cause electrical shorting between adjacent trace portions and can cause corrosion of the trace material.

Preferably, the coating 40 comprises a resin material. Typically, the resin material comprises a thermosetting resin material selected from the group consisting of epoxy resins, ultraviolet curable polyurethanes, ultraviolet curable acrylates and other like materials. An example ultraviolet curable polyurethane is one which. is commercially available from Emerson & Cumming Inc. under the product designation "Uniset" grade UV-7000. Most preferably, the coating 40 comprises an epoxy resin such as a novolac epoxy resin, a bisphenol epoxy resin, a phenol epoxy resin, and mixtures thereof. Other compounds or ingredients which may be combined with the epoxy resin or resins include a filler material such as a nonorganic silicon oxide filler, a pigment such as a phthalocyanine green and an anti-foaming agent such as a silicon type anti-foam agent. Preferably, the epoxy resin or resins and the other ingredients are combined with a solvent such as an ether glycol, an aromatic hydrocarbon and mixtures thereof so as to form an epoxy resin ink.

Before application, the epoxy resin ink is combined with a curing agent (also referred to as an activator) such as a denatured aromatic amine imidazole to form a coating treatment. Preferably, a solvent such as an ether glycol solvent is added to the denatured aromatic amine imidazole before the latter is combined with the ink. For example, a curing agent mixture may be prepared comprising by weight based on total weight of the curing agent mixture 50% denatured aromatic amine imidazole and 50% ether glycol solvent. The epoxy resin ink is preferably combined with the curing agent mixture in a by weight ratio of 100 parts ink to 6 parts curing agent mixture wherein the curing agent mixture includes the solvent.

The coating treatment may be applied via a conventional screen printing process or a spray coating process. The screen printing process involves providing a reel of flexible substrate material having a plurality of sets of metallic traces 34 formed thereon. The reel material is unwound from a first reel (not shown), moved through a conventional screen printing station (not shown) such that a layer of the coating treatment is applied over each set of metallic traces, and the coated substrate material is wound onto a second reel (not shown) before the coating treatment has fully cured or solidified. A conventional interleaf is provided over the coated reel material before it is wound onto the second reel. Preferably, the interleaf contacts the reel material only along its outer edges so as not to contact the coating treatment. The interleaf functions to space overlying sections of coated reel material from one another. The second reel having the coated reel material wound thereon is then placed in an oven heated to a temperature of about 140°C for about 50 minutes to evaporate the solvent in the coating treatment and/or effect curing of the resin.

During screen printing, the reel material is moved under a screen (not shown) having a mask (not shown) over it. The mask has one or more, preferably four, coating patterns formed in it. A conventional doctor blade (not shown) is moved over the mask and the screen so as to force the coating treatment through the mask and the screen and onto the reel material. Preferably, the process is intermittent such that the reel material is stationary during screen printing.

After the solvent has been driven off and the epoxy resin has substantially cured, the coating 40, at locations over the first trace portions 34a, has a thickness of from about 5 microns to about 30 microns and preferably about 20 microns. At locations over the exposed portions 32b of the substrate 32, the coating 40 has a thickness of from about 35 microns to about 50 microns and preferably about 40 microns.

If an ultraviolet curable resin is employed, the coated reel material passes under a source of ultraviolet radiation to effect curing of the resin before the coated reel material is wound onto the second reel. A heating step is typically not required when an ultraviolet curable resin is used as a solvent is usually not employed.

If a spray coating station is provided in place of the screen printing station, a mask is still provided and the coating treatment is sprayed using a conventional spraying apparatus onto exposed portions of the reel material.

Preferably, the flexible circuit 30 is secured to the container 12 such that the coating 40 faces toward the container 12.

The extending second trace portions 34b are coupled to the bond pads 20a via a conventional Tape Automated Bonding (TAB) bonding process. Preferably, the TAB bonding process is performed before either the printhead 20 or the flexible circuit 30 is secured to the container 12. Typically, there is a first row 35a of coupled bond pads 20a and second trace portions 34b and an opposing, second row 35b of coupled bond pads 20a and second trace portions 34b, see Fig. 3.

The container 12 may be formed from polyphenylene oxide, which is commercially available from the General Electric Company under the trademark "NORYL SE-1." The flexible substrate 32 is preferably formed from a polymeric material, such as a polyimide material commercially available from E.I. DuPont de Nemours & Co. under the trademark "KAPTON." In the illustrated embodiment, the metallic traces 34 are gold-coated copper traces. The specific materials from which the container 12, the substrate 32 and the metallic traces 34 are formed are mentioned herein for illustrative purposes only. Hence, in this invention, the materials from which these elements are formed are not intended to be limited to the specific ones disclosed herein.

The orifice plate 26 may be formed from a flexible polymeric material which is adhered to the heater chip 22 via an adhesive (not shown). Examples of polymeric materials from which the orifice plate 26 may be formed and adhesives for securing the plate 26 to the heater chip 22 are set out in commonly assigned patent application, U.S. Serial No. 08/519,906, entitled "METHOD OF FORMING AN INKJET PRINTHEAD NOZZLE STRUCTURE," by Tonya H. Jackson et al., filed on August 28,1995, Attorney Docket No. LE9-95-024, the disclosure of which is hereby incorporated by reference. As noted therein, the plate 26 may be formed from a polymeric material such as polyimide, polyester, fluorocarbon polymer, or polycarbonate, which is preferably about 15 to about 200 microns thick. Examples of commercially available plate materials include a polyimide material available from E.I. DuPont de Nemours & Co. under the trademark "KAPTON" and a polyimide material available from Ube (of Japan) under the trademark "UPILEX." The adhesive may comprise any B-stageable thermal cure resin including phenolic resins, resorcinol resins, urea resins, epoxy resins, ethylene-urea resins, furane resins, polyurethanes, and silicone resins. Other suitable adhesive materials include macromolecular thermoplastic, or hot melt, materials such as ethylene-vinyl acetate, ethylene ethylacrylate, polypropylene, polystryrene, polyamides, polyesters and polyurethanes. Alternatively, the orifice plate 26 may comprise a metal plate.

A die-attach adhesive (not shown), such as a heat curable epoxy-based polymer, is applied to a printhead receiving portion (not shown) of the container 12 so as to secure the printhead 20 to the container 12. A free-standing pressure sensitive adhesive film (not shown) may be used to secure the flexible circuit 30 to the container 12. A more detailed discussion of the manner in which the printhead 20 and the flexible circuit 30 are secured to the polymeric container 12 can be found in commonly assigned, copending patent application, U.S. Serial No.08/827,140, entitled "A PROCESS FOR JOINING A FLEXIBLE CIRCUIT TO A POLYMERIC CONTAINER AND FOR FORMING A BARRIER LAYER OVER SECTIONS OF THE FLEXIBLE CIRCUIT AND OTHER ELEMENTS USING AN ENCAPSULANT MATERIAL," by Singh et al., filed on March 27, 1997, and having Attorney Docket No.LE9-97-038, the disclosure of which is hereby incorporated by reference.

After the printhead 20 and the flexible circuit 30 have been attached to the container 12 but before the die-attach adhesive is cured, a bead of liquid encapsulant material 60 is applied over each of the two rows 35a and 35b of coupled bond pads 20a and extending second trace portions 34b. The liquid encapsulant material is preferably dispensed through a dispensing needle (not shown). The needle may have an oval cross section as set out in the above-mentioned patent application entitled "A PROCESS FOR JOINING A FLEXIBLE CIRCUIT TO A POLYMERIC CONTAINER AND FOR FORMING A BARRIER LAYER OVER SECTIONS OF THE FLEXIBLE CIRCUIT AND OTHER ELEMENTS USING AN ENCAPSULANT MATERIAL."

The encapsulant material 60 forms a first barrier layer 60a over row 35a and a second barrier layer 60b over row 35b. The encapsulant material 60 may comprise any polymeric material which, after it has substantially solidified or cured, is capable of forming an effective mechanical and chemical barrier layer over each of the two rows 35a and 35b of coupled bond pads 20a and extending second trace portions 34b. The barrier layers 60a and 60b protect the bond pads 20a which, in the illustrated embodiment, are made from aluminum, from corrosion due to exposure to ink. The encapsulant material 60 may comprise any conventional encapsulant material such as a urethane acrylate material which is commercially available from Emerson & Cumming Inc. under the trademark "UNISET UV-9000."

After the beads of encapsulant material 60 have been applied to the two rows 35a and 35b of coupled bond pads 20a and extending second portions 34b, the encapsulant material 60 is cured or allowed to solidify. Thereafter, the die-attach adhesive is cured by placing the cartridge 10 in a heated oven maintained at a temperature of about 110° C for approximately 45 minutes.

The following example is provided to illustrate and to facilitate the understanding of the invention. The example is not intended to be a restriction of the scope of the invention.

### EXAMPLE

An epoxy resin ink which is commercially available from Asahi Chemical Research Laboratory Company, Ltd. under the product designation CCR-232GF No. 6 Epoxy was combined with a curing agent to form a coating treatment.

The ink comprised by weight based on total weight of the ink 4% novolac epoxy resin; 31% bisphenol epoxy resin; 18% phenol epoxy resin; 19% nonorganic silicon oxide filler; 2% phthalocyanine green; 1% silicon type anti-foam agent; 12.5% ether glycol; and 12.5% aromatic hydrocarbon. The percent solids of the ink was 75%. The ink was combined with a curing agent mixture in a 100 to 6 parts by weight ratio of ink to curing agent mixture to form a coating treatment. For example, one pint of ink was combined with 0.06 pint of the curing agent mixture. The curing agent mixture comprised by weight based on total weight of the curing agent mixture 50% denatured aromatic amine imidazole and 50% ether glycol solvent. The coating treatment was allowed to sit at room temperature for about five hours before application to allow gas bubbles to come out of the coating treatment and to minimize coating curl once the epoxy had cured.

The coating treatment was applied to a reel of flexible substrate material having a plurality of sets of metallic traces 34 formed thereon via the screen printing process discussed above. A second reel having the coated reel material wound thereon was placed in an oven heated to a temperature of about 140°C for about 50 minutes to cause the solvent to evaporate. After the solvent was driven off and the epoxy resin had substantially cured, the coating 40, at locations over the first trace portions 34a, had a thickness of about 20 microns. At locations over the exposed portions 32b of the substrate 32, the coating 40 had a thickness of about 40 microns.

## Claims

1. A flexible circuit comprising:
a circuit substrate having first and second surfaces;
conductive traces formed on said first surface; and
a single layer resin material coating covering portions of said traces and first surface portions of said substrate, said substrate and said coating encapsulating said trace portions so as to prevent ink from reaching said trace portions.

2. A flexible circuit as set forth in claim 1, wherein said resin material comprises a thermosetting resin material.

3. A flexible circuit as set forth in claim 2, wherein said thermosetting resin material comprises an epoxy resin.

4. A flexible circuit as set forth in claim 2, wherein said thermosetting resin material is selected from the group consisting of epoxy resins, polyurethanes and acrylates.

5. A flexible circuit as set forth in claim 1, wherein said traces comprise first and second portions, said first portions being formed on said circuit substrate and defining said covered portions and said second portions extending beyond an edge of said circuit substrate.

6. A flexible circuit comprising:
a circuit substrate having first and second surfaces;
conductive traces formed on said first surface; and
a single layer resin material coating covering portions of said traces and first surface portions of said substrate, said coating having a thickness greater than or equal to about 20 microns, said substrate and said coating encapsulating said trace portions so as to prevent ink from reaching said trace portions.

7. A flexible circuit as set forth in claim 6, wherein said resin material comprises a thermosetting resin.

8. A flexible circuit as set forth in claim 7, wherein said thermosetting resin comprises an epoxy resin.

9. A flexible circuit as set forth in claim 7, wherein said thermosetting resin is selected from the group consisting of epoxy resins, polyurethanes and acrylates.

10. A flexible circuit as set forth in claim 6, wherein said traces comprise first and second portions, said first portions being formed on said circuit substrate and defining said covered portions and said second portions extending beyond an edge of said circuit substrate.

11. A process for forming a flexible circuit comprising the steps of:
providing a circuit substrate having first and second surfaces;
forming conductive traces on said first surface; and
forming a single layer resin material coating over portions of said traces and first surface portions of said substrate, said substrate and said coating encapsulating said trace portions so as to prevent ink from reaching said trace portions.

12. A process as set forth in claim 10, wherein said step of forming a single layer resin material coating comprises the steps of:
combining an epoxy resin, a curing agent and a solvent so as to form a thermosetting resin coating treatment; and
applying said coating treatment to said trace portions and said first surface portions of said substrate.

13. A process as set forth in claim 12, wherein said solvent comprises an ether glycol.

14. A process as set forth in claim 12, wherein said curing agent comprises a denatured aromatic amine imidazole.

15. A process as set forth in claim 12, wherein said applying step comprises the step of screen printing said coating treatment onto said trace portions and said first surface portions of said substrate.

16. A process as set forth in claim 12, wherein said applying step comprises the step of spraying said coating treatment onto said trace portions and said first surface portions of said substrate.

17. A process as set forth in claim 11, wherein said step of forming conductive traces on said first surface comprises the step of forming traces having first and second portions, said first portions being formed on said circuit substrate and defining said covered portions and said second portions extending beyond an edge of said circuit substrate.

18. A process for forming a flexible circuit comprising the steps of:
providing a circuit substrate having first and second surfaces;
forming conductive traces on said first surface; and
forming a single layer resin material coating over portions of said traces and first surface portions of said substrate, said coating having a thickness greater than or equal to about 20 microns, said substrate and said coating encapsulating said trace portions so as to prevent ink from reaching said trace portions.

19. A process as set forth in claim 18, wherein said step of forming a single layer resin material coating comprises the steps of:
combining an epoxy resin, a curing agent and a solvent so as to form a thermosetting resin coating treatment; and
applying said coating treatment to said trace portions and said first surface portions of said substrate.

20. A process as set forth in claim 19, wherein said solvent comprises an ether glycol.

21. A process as set forth in claim 19, wherein said curing agent comprises a denatured aromatic amine imidazole.

22. A process asset forth in claim 19, wherein said applying step comprises the step of screen printing said coating treatment onto said trace portions and said first surface portions of said substrate.

23. A process as set forth in claim 19, wherein said applying step comprises the step of spraying said coating treatment onto said trace portions and said first surface portions of said substrate.

24. A process as set forth in claim 18, wherein said step of forming conductive traces on said first surface comprises the step of forming traces having first and second portions, said first portions being formed on said circuit substrate and defining said covered portions and said second portions extending beyond an edge of said circuit substrate.

25. A process as set forth in claim 18, wherein said resin material is selected from the group consisting of epoxy resins, polyurethanes and acrylates.
